# DEMANDE DE BREVET EUROPEEN

(11) **EP 2 840 370 A1**
(43) Date de publication de la demande: **25.02.2015**
(21) Numéro de dépôt: 14181261.0
(22) Date de dépôt: 18.08.2014
(51) Int. Cl.: G01J 5/20

(54) **Détecteur bolométrique à bolométre de compensation à thermalisation renforcée**

(30) Priorité: 22.08.2013 FR 1358128
(71) Demandeur: COMMISSARIAT A L'ENERGIE ATOMIQUE ET AUX ENERGIES ALTERNATIVES, 75015 Paris (FR)
(72) Inventeur: Imperinetti, Pierre, 38180 SEYSSINS (FR); Arnaud, Agnès, 38420 SAINT JEAN LE VIEUX (FR); Rolland, Emmanuel, 38560 JARRIE (FR)
(74) Mandataire: Cabinet Laurent & Charras

(57) **Abrégé**

Détecteur bolométrique comportant :
▪ un substrat ;
▪ des micro-ponts bolométriques de détection suspendus au-dessus du substrat et thermiquement isolés du substrat;
▪ des micro-ponts bolométriques de compensation suspendus au-dessus du substrat et thermalisés au substrat; et
▪ un circuit de lecture formé dans le substrat pour appliquer une polarisation aux micro-ponts de détection et au micro-ponts de compensation et pour former des différences entre des signaux produits par les micro-ponts de détection et des signaux produits par les micro-ponts de compensation sous l'effet de la polarisation appliquée,

Chaque micro-pont de détection et chaque micro-pont de compensation comportent des clous d'ancrage (16) électriquement conducteurs connectés au circuit de lecture, une membrane (12) fixée aux clous d'ancrage (16) au-dessus du substrat et un élément thermométrique agencé dans la membrane (12). Le détecteur comporte en outre des éléments de court-circuit thermique (326) entre la membrane (12) de chaque micro-pont de compensation et le substrat.

Les éléments de court-circuit thermique (326) sous chaque micro-pont de compensation comportent des motifs métalliques agencés sous l'élément bolométrique du micro-pont de compensation et au contact de la membrane (12) du micro-pont de compensation et du substrat.

## Description

### DOMAINE DE L'INVENTION

La présente invention a trait au domaine des détecteurs bolométriques, et plus particulièrement aux détecteurs bolométriques à micro-ponts suspendus associés à une ou plusieurs branches d'ébasage comprenant des bolomètres de compensation. L'invention trouve particulièrement application dans la détection bolométrique à température ambiante, la détection de rayonnement infrarouge, notamment l'imagerie infrarouge, la détection de rayonnement térahertz, notamment l'imagerie térahertz, la thermographie, et la détection de gaz par la mesure de l'absorption optique dans le spectre infrarouge.

### ETAT DE LA TECHNIQUE

Usuellement, un détecteur bolométrique résistif mesure la puissance d'un rayonnement incident dans la gamme infrarouge. Il comprend à cet effet un élément bolométrique résistif absorbant qui convertit le flux lumineux en flux calorifique, ce qui produit une élévation de température dudit élément par rapport à une température de référence. Cette augmentation de température induit alors une variation de la résistance électrique de l'élément absorbant, provoquant des variations de tension ou de courant aux bornes de celui-ci. Ces variations électriques constituent le signal délivré par le capteur.

Toutefois, la température de l'élément bolométrique est usuellement dépendante en grande partie de l'environnement de celui-ci, et notamment celle du substrat qui comprend le circuit électronique de lecture. Afin d'insensibiliser au maximum l'élément absorbant de son environnement, et ainsi augmenter la sensibilité du détecteur, l'élément bolométrique est généralement isolé thermiquement du substrat.

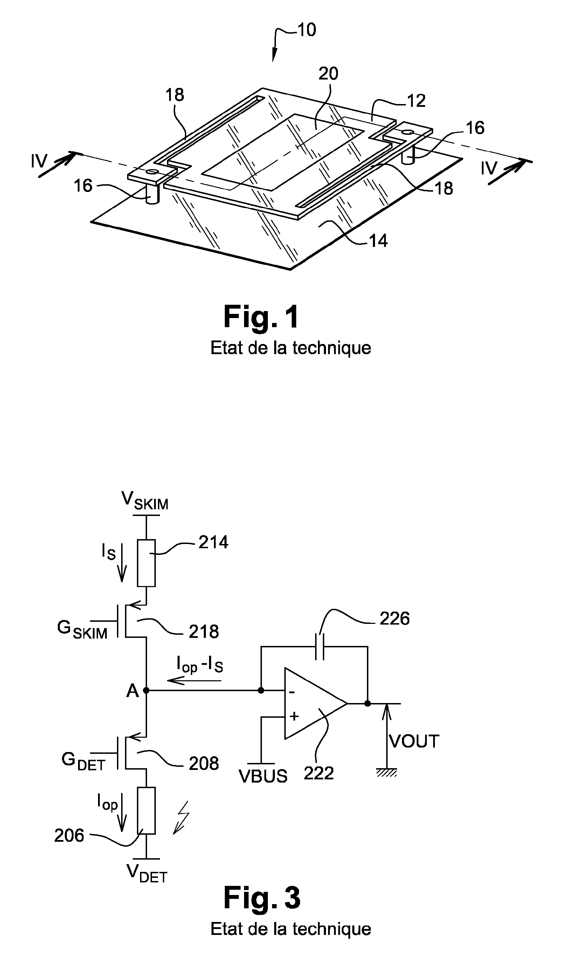

La figure 1 est une vue schématique simplifiée en perspective d'un détecteur bolométrique résistif élémentaire 10 de l'état de la technique pour la détection infrarouge illustrant ce principe d'isolation thermique. Ce détecteur élémentaire, usuellement désigné par le terme de « bolomètre » ou de « micro-pont bolométrique », ici sous la forme d'une membrane suspendue, fait classiquement partie d'une matrice de détecteurs élémentaires à une ou deux dimensions.

Le bolomètre **10** comporte une fine membrane **12** absorbant le rayonnement incident, suspendue au-dessus d'un substrat - support **14** par l'intermédiaire de deux clous d'ancrage conducteurs **16** auxquels elle est fixée par deux bras d'isolation thermique **18.** La membrane **12** comprend usuellement une couche d'isolant électrique, comme par exemple du SiO₂, du SiO, du SiN, du SiON, du ZnS ou autre, qui assure la rigidité mécanique de la membrane **12,** ainsi qu'une couche métallique d'interconnexion électrique déposée sur la couche d'isolant.

Une couche mince **20** de matériau thermométrique résistif est par ailleurs déposée au centre de la membrane **12** sur la couche métallique d'interconnexion, notamment une couche en un matériau semi-conducteur, tel que du silicium polycristallin ou amorphe de type p ou n faiblement ou fortement résistif, ou bien un oxyde de vanadium (V₂O₅, VO₂) élaboré dans une phase semi-conductrice, ou bien du titane, de l'oxyde de titane (TiOx), ou de l'oxyde de nickel (NiOx). Enfin, le substrat - support **14** comprend un circuit électronique intégré sur une plaquette de silicium, usuellement connu sous l'expression « circuit de lecture ». Le circuit de lecture comporte d'une part les éléments de stimuli et de lecture de l'élément thermométrique **20,** et d'autre part les composants de multiplexage qui permettent de sérialiser les signaux issus des différents éléments thermométriques présents dans le détecteur matriciel.

En fonctionnement, la membrane **12** s'échauffe sous l'effet d'un rayonnement électromagnétique incident et la puissance calorifique produite est transmise à la couche **20** de matériau thermométrique. Périodiquement, le circuit de lecture agencé dans le substrat **14** polarise la membrane **12** en soumettant les clous **16** à une tension de polarisation et recueille le courant circulant dans l'élément thermométrique **20** pour en déduire une variation de sa résistance, et donc le rayonnement incident à l'origine de ladite variation.

Si le fait de suspendre l'élément thermométrique au-dessus du substrat permet à celui-ci de subir une variation de résistance électrique sous l'effet du rayonnement incident, cette variation reste cependant infime. En effet, dans le cadre du détecteur bolométrique élémentaire de la figure 1, à 300°K, une variation de 1 K de la scène observée induit une variation relative de la résistance électrique de la couche thermométrique **20** d'environ 0,04%. En effet, l'essentiel de la valeur de la résistance électrique de cet élément est principalement dicté par l'environnement direct de la membrane. Notamment, le substrat influence la température de la membrane **12** via la conduction thermique au travers des clous **16** et des bras **18** qui fixent environ 70% de la valeur de la résistance électrique de la couche **20.** Dans le meilleur des cas, moins de 10 % de la valeur de la résistance électrique sont fixés par le rayonnement incident, et plus généralement moins de 1%. L'essentiel de la résistance électrique de la couche de matériau thermométrique **20** étant fixé par des éléments étrangers à la scène observée, en l'absence de mesure particulière, la dynamique de lecture du détecteur est donc très limitée, ce qui rend un tel détecteur très difficile d'utilisation.

Pour pallier ce problème, le détecteur bolométrique élémentaire est associé à une structure de compensation, ou « d'ébasage », visant à éliminer la part non utile du signal issu de la lecture de l'élément thermométrique de la membrane, usuellement connue sous le nom de « mode commun ».

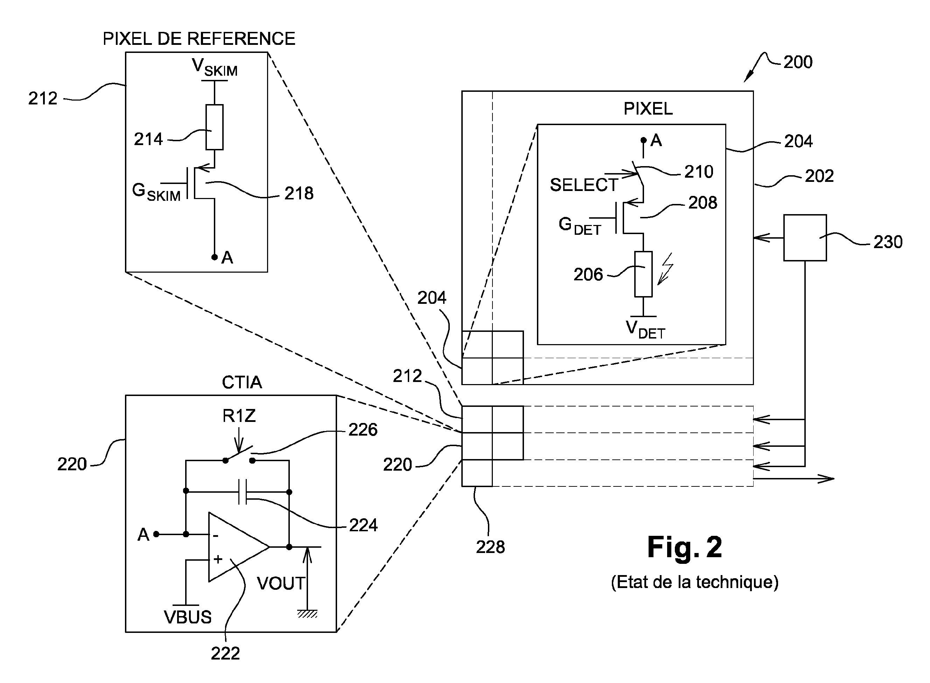

La figure 2 est un schéma électrique d'un détecteur bolométrique infrarouge **200** de l'état de la technique comprenant une telle structure d'ébasage. Le détecteur **200** comprend une matrice bidimensionnelle **202** d'éléments unitaires de détection **204,** ou « pixels », comprenant chacun un bolomètre sensible **206** sous la forme d'une membrane suspendue au-dessus d'un substrat, par exemple le bolomètre illustré à la figure 1, connecté à l'une de ses bornes à une tension constante « V_{DET} » et à l'autre de ses bornes à un transistor MOS de polarisation **208** réglant la tension aux bornes du bolomètre **206** au moyen d'une tension de commande de grille « G_{DET} ». Le pixel **204** comprend également un interrupteur de sélection **210,** connecté entre le transistor MOS **208** et un noeud « A » prévu pour chaque colonne de la matrice **202,** et piloté par un signal de commande « SELECT », permettant la sélection du bolomètre **206** pour sa lecture. L'ensemble bidimensionnel de membranes suspendues, usuellement désigné sous le terme de « rétine », est placé dans un boitier hermétique au droit d'une fenêtre transparente au rayonnement infrarouge à détecter et dans le plan focal d'une optique (non représentée). Le transistor **208** et l'interrupteur **210** sont quant à eux usuellement formés dans le substrat sous l'emprise de la membrane du bolomètre **206.**

Le détecteur **200** comporte également, en pied de chaque colonne de la matrice **202,** une structure d'ébasage **212** comportant un bolomètre de compensation **214** identique aux bolomètres **206** des pixels **204** du point de vue électro-thermique et rendu insensibles au rayonnement incident issu de la scène à observer en étant « thermalisés » au substrat **14.** La résistance électrique du bolomètre **214** est ainsi essentiellement dictée par la température du substrat **14.**

Le bolomètre **214** est par ailleurs connecté à l'une de ses bornes à une tension constante « V_{SKIM} », et la structure d'ébasage **212** comporte en outre un transistor MOS de polarisation **218** réglant la tension aux bornes du bolomètre **214** au moyen d'une tension de commande de grille « G_{SKIM} » et connecté entre l'autre borne du bolomètre **214** et le noeud « A ».

Le détecteur **200** comporte également, en pied de chaque colonne de la matrice **202** un intégrateur **220** de type CTIA (pour « capacitive transimpedance amplifier ») comportant par exemple un amplificateur **222** et une capacité **224** connectée entre l'entrée inverseuse et la sortie de l'amplificateur **222.** La borne inverseuse et la borne non-inverseuse de ce dernier sont par ailleurs connectées respectivement au noeud « A » et à une tension constante « VBUS ». Un interrupteur **226,** piloté par un signal « RAZ », est également prévu en parallèle de la capacité **224,** pour la décharge de celui-ci. Les sorties des CTIA **220** sont enfin par exemple connectées à des échantillonneurs bloqueurs **228** respectifs pour la délivrance des tensions « Vout » des CTIA en mode multiplexé.

Le détecteur **200** comprend enfin une unité de gestion **230** commandant les différents interrupteurs décrits précédemment. En fonctionnement, la matrice **202** est lue ligne par ligne. Pour lire une ligne de la matrice **202,** les interrupteurs **210** de la ligne de pixels 204 sont fermés et les interrupteurs **210** des autres lignes sont ouverts. Après une phase de décharge des condensateurs des CTIA en pied de colonne, réalisée par la fermeture des interrupteurs **226** suivi de leur ouverture, il est ainsi obtenu un circuit tel que représenté sur la figure 3 pour chaque pixel de la ligne en cours de lecture. Un courant « Iop » circule dans le bolomètre **206** du pixel sous l'effet de sa polarisation en tension par le transistor MOS **208,** et un courant « Is » circule dans le bolomètre **214** de la structure d'ébasage sous l'effet de sa polarisation en tension par le transistor MOS **218.** La différence de courant résultante est intégrée par le CTIA **220** pendant une durée d'intégration prédéterminée « Tint ». La tension de sortie « Vout » du CTIA **220** représente ainsi une mesure de la variation de la résistance du bolomètre **206** provoquée par le rayonnement incident à détecter, puisque la partie non utile du courant « Iop », à savoir la température du substrat, et donc la température ambiante, est compensée, au moins en partie, par le courant « Is » spécifiquement produit pour reproduire cette partie non utile. La température du substrat étant compensée, celle-ci peut librement varier et il n'est donc pas besoin de prévoir des dispositifs de contrôle de la température du substrat, notamment un module Peltier.

Selon une première conception particulière de l'état de la technique, le bolomètre de compensation **214** comporte un empilement identique à l'empilement constitutif de la partie suspendue de la membrane des bolomètres **206,** et donc la membrane suspendue des bolomètres **206** sans le système d'isolation thermique comportant essentiellement les bras **18** d'isolation thermique, formé directement sur et/ou dans le substrat **14.** Cette première configuration nécessite cependant une conception différente de celle des bolomètres sensibles, ce qui complexifie la fabrication du détecteur.

Selon une seconde configuration particulière de l'état de la technique, le bolomètre de compensation **214** comporte l'ensemble des éléments constitutifs des bolomètres sensibles **206** de la matrice **202.** La membrane du bolomètre **214** est thermalisée au substrat par des éléments de faible résistance thermique, par exemple des éléments métalliques, solidaires de la membrane et du substrat, et agencés en périphérie de la membrane. Ces éléments forment ainsi des court-circuits thermiques entre la membrane et le substrat afin que ces éléments présentent la même température.

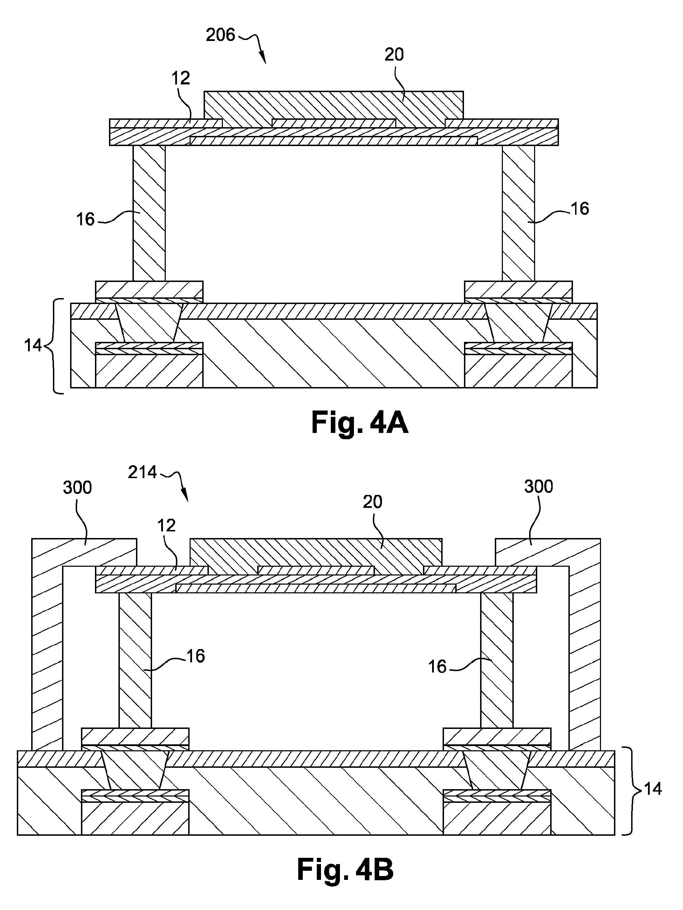

Les figures 4A et 4B sont respectivement des vues en coupe d'un bolomètre sensible et d'un bolomètre de compensation de l'état de la technique, par exemple du type décrit en relation avec la figure 1, les vues en coupe correspondant au plan de coupe IV-IV de la figure 1. Comme on peut le constater, le bolomètre de compensation **214** diffère du bolomètre sensible **206** par deux éléments **300** métalliques disposés de part et d'autre de la membrane bolométrique **12** en périphérie de celle-ci. Cette configuration permet de fabriquer le bolomètre de compensation **214** de manière sensiblement identique à la fabrication du bolomètre sensible **206,** hormis les éléments **300.** Grâce aux éléments **300,** la fabrication du détecteur est donc plus simple et moins onéreuse mais la fabrication du bolomètre de compensation reste malgré tout complexe.

Si la structure d'ébasage venant d'être décrite permet d'obtenir des résultats satisfaisants, on observe cependant que la thermalisation des bolomètres de compensation **214** au substrat est insuffisante pour compenser exactement la température de celui-ci. De plus, les court-circuits thermiques **300** étant formés en périphérie de la membrane **12** des bolomètres de compensation **214,** ces derniers nécessitent des étapes technologiques de fabrication supplémentaires et sont plus encombrants que les bolomètres sensibles **206,** ce qui nuit à la miniaturisation et/ou au facteur de remplissage des bolomètres de compensation.

On notera que le problème se pose quel que soit le type de circuit utilisé pour polariser et « lire » la matrice de bolomètres sensibles. Dans l'état de la technique précédemment décrit, la polarisation est réalisée en tension. Le problème se pose également dans les détecteurs polarisés en courant, le signal de lecture étant alors une différence entre les tensions aux bornes de bolomètres sensibles et les tensions aux bornes des bolomètres de compensation.

De même, le problème se pose quel que soit le nombre de bolomètres de compensation prévus dans le détecteur. Notamment, un bolomètre de compensation peut être prévu pour chaque bolomètre sensible. De même, un bolomètre de compensation peut être constitué de la mise en série de bolomètres de compensation unitaires du type venant d'être décrit afin de réduire par exemple le bruit colonnaire. Le problème se pose donc dans les mêmes termes.

### EXPOSE DE L'INVENTION

Le but de la présente invention est de proposer un détecteur bolométrique comportant des bolomètres de compensation à base de membranes suspendues présentant une thermalisation accrue au substrat.

A cet effet, l'invention a pour objet un détecteur bolométrique comportant :
■ un substrat ;
■ des micro-ponts bolométriques de détection suspendus au-dessus du substrat et thermiquement isolés du substrat ;
■ des micro-ponts bolométriques de compensation suspendus au-dessus du substrat et thermalisés au substrat; et
■ un circuit de lecture formé dans le substrat pour appliquer une polarisation aux micro-ponts de détection et au micro-ponts de compensation et pour former des différence entre des signaux produits par les micro-ponts de détection et des signaux produits par les micro-ponts de compensation sous l'effet de la polarisation appliquée,

Dans le détecteur, chaque micro-pont de détection et chaque micro-pont de compensation comporte des clous d'ancrage électriquement conducteurs connectés au circuit de lecture, une membrane fixée aux clous d'ancrage au-dessus du substrat et un élément thermométrique agencé dans la membrane, et le détecteur comporte en outre des éléments de court-circuit thermique entre la membrane de chaque micro-pont de compensation et le substrat.

Selon l'invention, les éléments de court-circuit thermique sous chaque micro-pont de compensation comportent des motifs métalliques agencés sous l'élément bolométrique de chaque micro-pont de compensation et au contact de membrane du micro-pont de compensation et du substrat.

En d'autres termes, le volume existant entre la membrane et le substrat est utilisé pour loger des liens thermiques entre ces deux éléments. Non seulement ces liens sont disposés au plus proche de l'élément thermométrique à thermaliser, mais en outre il est possible de prévoir un nombre important de court-circuits thermiques. Une thermalisation accrue est donc obtenue. De plus, la thermalisation peut être obtenue à l'aide de ces seuls court-circuits, sans l'emploi d'éléments de court-circuit en périphérie de la membrane. L'encombrement des bolomètres de compensation peut ainsi être réduit. Enfin, la fabrication des bolomètres de compensation peut être simplifiée en fabricant les éléments de court-circuit de manière identique aux clous d'ancrage suspendant les membranes des micro-ponts de détection et de compensation.

Selon un mode de réalisation, les membranes des micro-ponts de compensation sont identiques aux membranes des micro-ponts de détection. Notamment, les micro-ponts de compensation sont identiques aux micro-ponts de détection.

Selon un mode de réalisation, les motifs métalliques sont identiques aux clous d'ancrage suspendant la membrane du micro-pont de compensation.

Selon un mode de réalisation, les motifs métalliques sont électriquement isolés de l'élément thermométrique du micro-pont de compensation.

Selon un mode de réalisation, les motifs métalliques sont sensiblement des cylindres de de section circulaire d'un diamètre compris entre 0,25 micromètre et 5 micromètres.

Selon un mode de réalisation, le nombre de motifs métalliques est compris entre 0,5 et 1,5 motif par µm², notamment 1 motif par µm². Notamment, avec des motifs cylindriques d'un diamètre compris entre 0,5 µm et 5 µm, le nombre de motifs pour une membrane de 10x10 µm² est compris entre 1 et 100.

L'invention a également pour objet un procédé de fabrication d'un détecteur du type précité, qui comporte :
■ la réalisation du substrat et du circuit de lecture, le circuit de lecture comportant des plots métalliques aux endroits prévus pour les clous d'ancrage des micro-ponts de détection et des micro-ponts de compensation ;
■ le dépôt sur la surface du substrat d'une couche sacrificielle ;
■ la réalisation de trous traversants dans la couche sacrificielle aux endroits prévus pour les clous d'ancrage et pour les motifs de court-circuit thermique;
■ la métallisation des trous traversants ;
■ la réalisation des membranes des micro-ponts de détection et des micro-ponts de compensation sur la couche sacrificielle ; et
■ le retrait de la couche sacrificielle.

### BREVE DESCRIPTION DES FIGURES

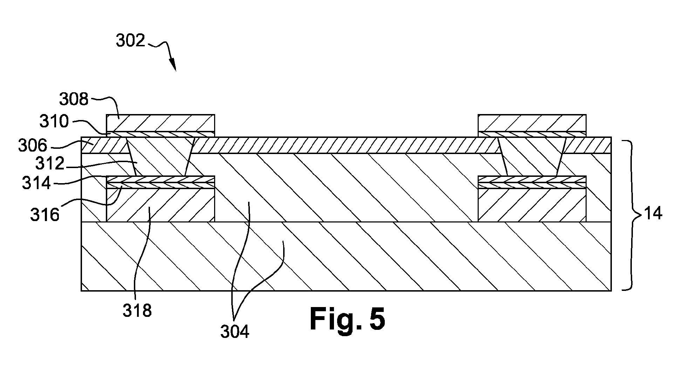

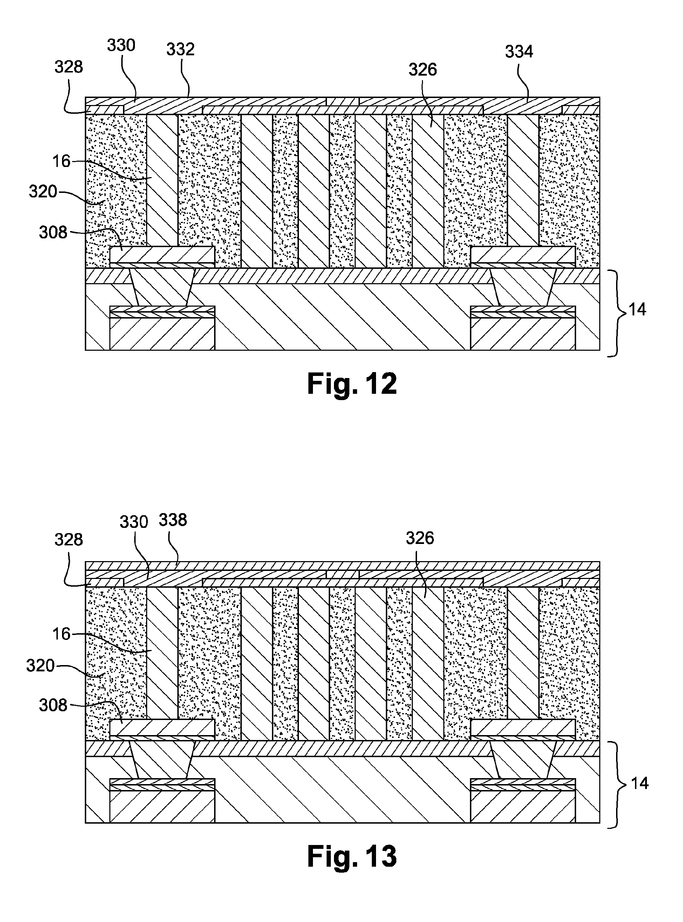

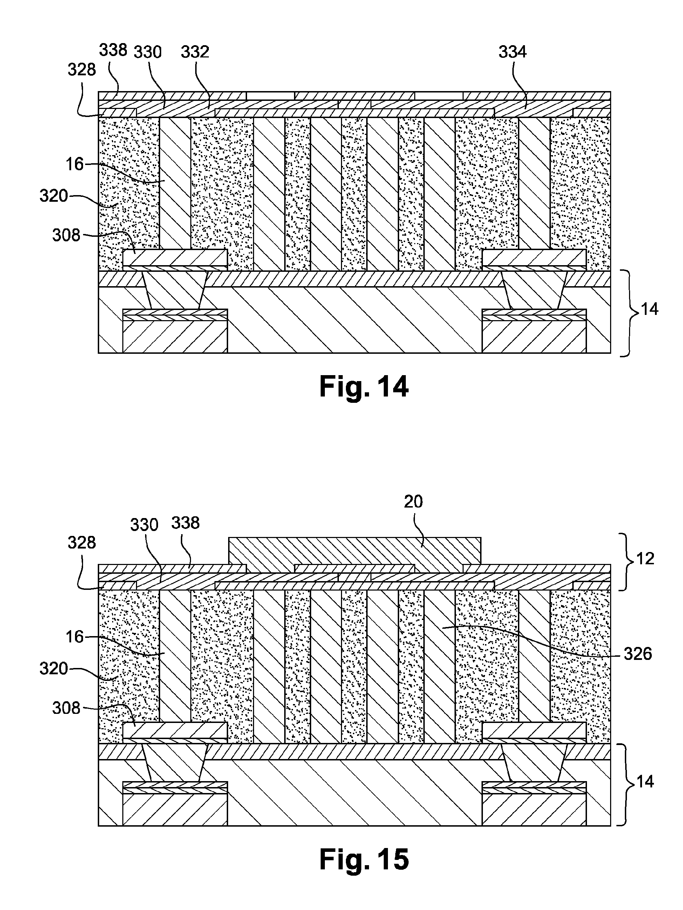

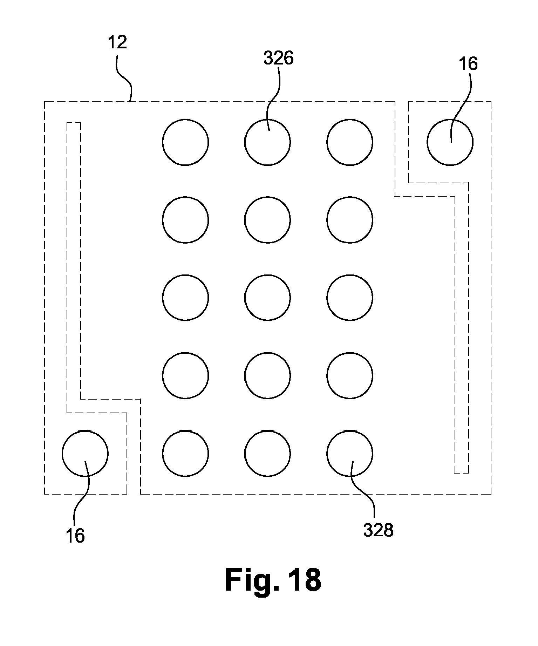

L'invention sera mieux comprise à la lecture de la description qui va suivre, donnée uniquement à titre d'exemple, et réalisée en relation avec les dessins annexés, dans lesquels des références identiques désignent des éléments identiques ou analogues, et dans lesquels :
■ la figure 1 est une vue schématique en perspective d'un détecteur bolométrique élémentaire de l'état de la technique, déjà décrit ci-dessus;
■ la figure 2 est un schéma électrique d'un détecteur bolométrique infrarouge de l'état de la technique, déjà décrit ci-dessus ;
■ la figure 3 est un schéma électrique illustrant la lecture d'un bolomètre sensible du détecteur de la figure 2 à l'aide d'une structure d'ébasage ;
■ les figures 4A et 4B sont des vues schématiques en coupe selon le plan IV-IV de la figure 1 respectivement d'un bolomètre sensible et d'un bolomètre de compensation de l'état de la technique ;
■ les figures 5 à 17 sont des vues schématiques en coupe selon le plan IV-IV d'un procédé de fabrication d'un bolomètre de compensation selon l'invention ; et
■ la figure 18 est une vue schématique de dessus d'un bolomètre de compensation pourvu des éléments de court-circuit selon l'invention.

### DESCRIPTION DETAILLEE DE L'INVENTION

Il va à présent être décrit en relation avec les figures 5 à 8 un procédé de fabrication d'un bolomètre de compensation **214** selon l'invention constitutif d'un détecteur bolométrique, par exemple un détecteur du type décrit en relation avec les figures 1 à 3.

Le procédé débute par la fabrication d'un substrat **14** et d'un circuit de lecture **302** du détecteur, comme cela est connu en soi de l'état de la technique (figure 5). Par exemple, le substrat **14** comporte une couche de silicium intégrant des circuits CMOS pour la réalisation des fonctions de lecture (non représentés), par exemple les composants et circuits illustrés à la figure 2 pour polariser et lire les bolomètres **206, 214,** couche sur laquelle est formée une couche de diélectrique **304,** par exemple en oxyde de silicium (SiO₂), recouverte d'une couche de nitrure de silicium (SiₓN_{y}) **306.** La couche diélectrique **304** intègre le niveau d'interconnexion le plus supérieur du circuit de lecture **302.** Ce niveau d'interconnexion comporte des plages de connexion **308, 310** aux emplacements prévus pour les clous d'ancrage **16** des bolomètres sensibles et des bolomètres de compensation, des vias métalliques **312,** et des plages d'interconnexion inférieure **314, 316, 318** connectées aux plages **306, 308** à la surface du substrat **14** par les vias **312.**

Différentes options techniques peuvent être mises en oeuvre pour réaliser l'interconnexion entre des plages de niveau différents. Une première option consiste à utiliser des plages de métal **308, 318** constituées d'une couche d'aluminium, avantageusement recouverte sur leurs faces en regard d'une ou deux couches de titane ou de nitrure de titane **310, 314, 316,** et d'utiliser un via **310** en tungstène. Selon une autre option, le via **310** est réalisé en cuivre selon un procédé de fabrication connu, appelé procédé damascène qui consiste à remplir des tranchées d'un diélectrique **304** avec du cuivre.

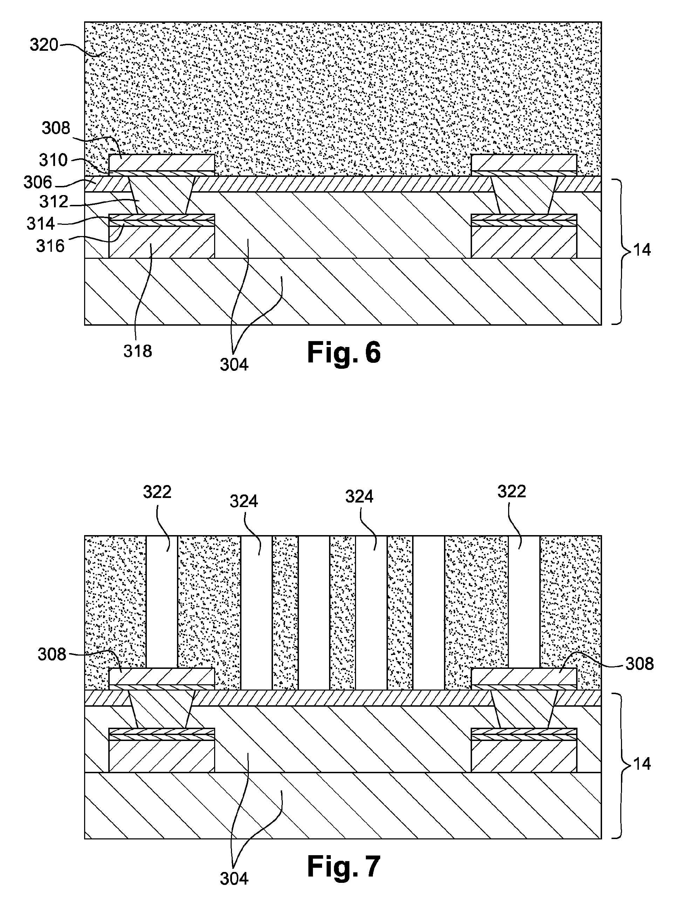

Dans une étape suivante du procédé, une couche sacrificielle **320** est déposée sur le substrat **14** et les plages d'interconnexion **308,** avantageusement constituée d'un polymère organique tel que du polyimide ou du benzocyclobutène (BCB) ou constituée d'une couche minérale en oxyde de silicium ou en silicium (figure 6). La couche organique **320** est déposée par exemple par enduction centrifuge (ou « spin coating ») et subit après son dépôt un traitement thermique de réticulation pour la stabiliser thermiquement. L'épaisseur de la couche sacrificielle **320** dépend de la hauteur désirée entre les membranes des bolomètres sensibles et des bolomètres de compensation et le substrat, cette hauteur étant usuellement comprise entre 1 micromètre et 5 micromètres. L'épaisseur de la couche sacrificielle organique **320** peut être aisément réglée en ajustant la vitesse de rotation du dépôt par enduction centrifuge.

Une fois la couche sacrificielle **320** déposée, des trous traversants **322** sont réalisés dans l'épaisseur totale de la couche **320** au-dessus des plages **308** pour les bolomètres sensibles et les bolomètres de compensation.

Pour les bolomètres de compensation, des trous traversants supplémentaires **324** sont réalisés dans l'épaisseur totale de la couche **320** en des endroits prévus pour la réalisation ultérieure d'éléments de court-circuit thermiques, à savoir sous les membranes des bolomètres de compensation ultérieurement réalisées sur la couche sacrificielle **320,** comme expliqué ci-après (figure 7). Les trous **322, 324** sont avantageusement réalisés conjointement à l'aide de la même technique, notamment de photolithogravure. Ces trous prennent par exemple la forme de trous cylindriques de section circulaire d'un diamètre compris entre 0,25 micromètre et 5 micromètre.

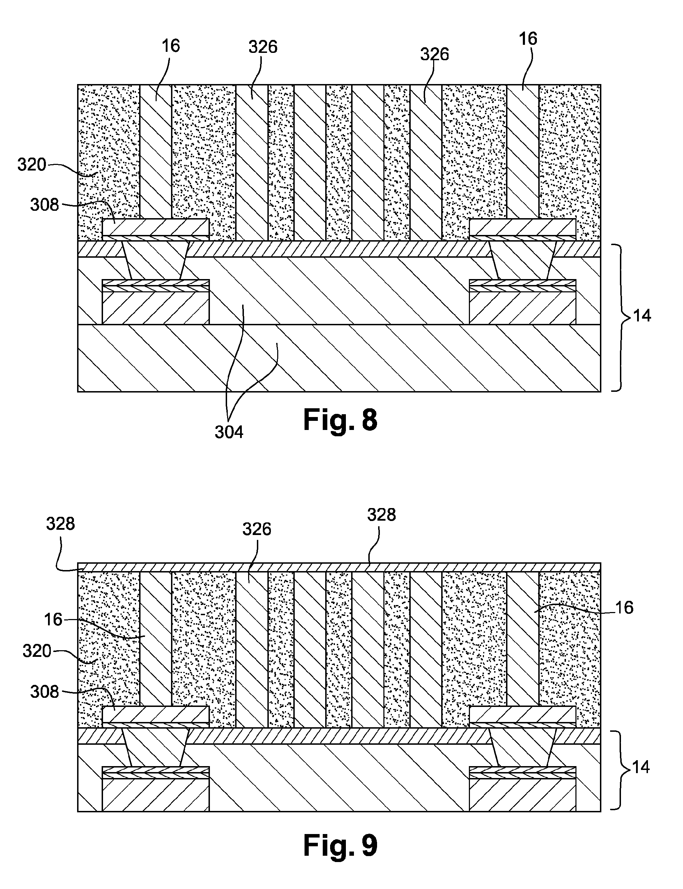

Les trous **322, 324** sont ensuite métallisés, par exemple remplis de tungstène et/ou de cuivre à l'aide d'un procédé de type damascène (figure 8). Les clous d'ancrage **16** des bolomètres sensibles et des bolomètres de compensation sont fabriqués, ainsi qu'un ensemble d'éléments **326** de court-circuit thermique vers le substrat **14** des bolomètres de compensation.

Le procédé se poursuit par le dépôt d'une couche de diélectrique **328** sur la couche sacrificielle **320,** au moins aux emplacements prévus pour les membranes des bolomètres de compensation, et de manière avantageusement également aux emplacements prévus pour les membranes des bolomètres sensibles afin d'obtenir des membranes identiques pour les deux types de bolomètre (figure 9). La couche **328** est par exemple déposée sur la totalité de la couche sacrificielle **320.** La couche de diélectrique **328,** par exemple constituée de SiN, de SiON, de Si ou de SiO₂, a pour fonction d'isoler électriquement les membranes des bolomètres de compensation des éléments de court-circuit thermique **326.**

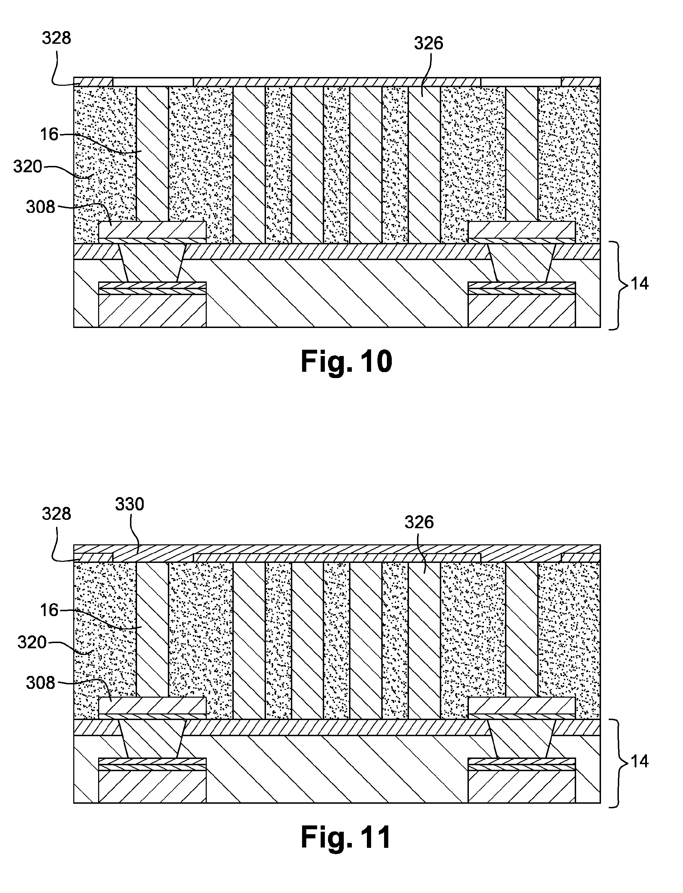

La couche de diélectrique **326** est ensuite gravée au-dessus des clous d'ancrage **16** pour dégager ceux-ci (figure 10).

La fabrication de la membrane **12** des bolomètres de détection et de compensation se poursuit alors de manière classique.

Par exemple, une couche **330** de matériau absorbant le rayonnement à détecter est déposée sur la couche de diélectrique **328** et les clous d'ancrage 16 dégagés (figure 11). La couche absorbante **330** est également électriquement conductrice pour permettre l'application d'une polarisation électrique au travers des clous **16.** Par exemple, la couche absorbante **330** est constituée de titane (Ti), de nitrure de titane (TiN), de tugnstène de titane (TiW), de nitrate d'amonium (TaN), ou de nitrate de tungstène (WN).

La couche **330** est ensuite gravée, afin de définir deux motifs distincts **332, 334** servant d'électrodes de polarisation du matériau thermométrique ultérieurement déposé (figure 12). Une seconde couche diélectrique **338,** de constitution par exemple identique à la couche diélectrique **328,** est alors déposée sur la couche absorbante **330** (figure 13) et la couche **338** est gravée pour définir deux ouvertures vers la couche d'absorbant **330** de sorte que les deux électrodes **332, 334** seront électriquement isolés une fois l'élément en matériau thermométrique déposé (figure 14). L'élément en matériau thermométrique **20,** par exemple constitué de silicium amorphe ou d'oxyde de vanadium, est alors déposé sur la couche de diélectrique **338** de manière à remplir les ouvertures vers la couche **330** finalisant ainsi l'empilement technologique de la membrane 12 des bolomètres (figure 15).

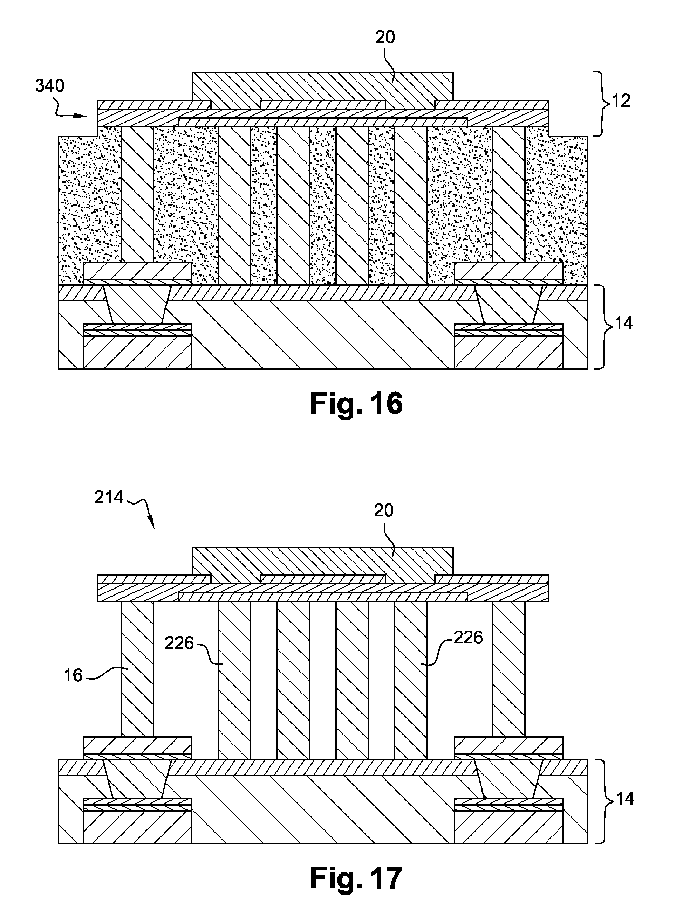

Les membranes sont ensuite individualisées par gravure de tranchées **340** dans l'empilement des membranes **12** (figure 16) et la couche sacrificielle **320** est retirée, libérant ainsi les membranes **12** des bolomètres (figure 17).

Il est ainsi obtenu des bolomètres de compensation qui sont structurellement identiques aux bolomètres sensibles mais dont la liaison thermique avec le substrat est différente en raison de la présence des éléments de court-circuit thermiques **326.** Ainsi, les membranes des bolomètres de compensation et les membranes de bolomètres de compensation sont identiques, et donc présentent les mêmes propriétés optiques et électriques. Non seulement, cela simplifie le procédé de fabrication du détecteur bolométrique, mais cela implique également une compensation du mode commun plus précise.

On note notamment que les éléments de court-circuits **326** sont électriquement isolés de la couche de matériau thermométrique **20** par une couche diélectrique **328,** de sorte que la résistance électrique de cette couche n'est pas modifiée par la présence des éléments de court-circuit **326.**

La figure 18 illustre pour un bolomètre de compensation un exemple de clous d'ancrage **16** et les éléments de court-circuit thermique **326** vus de dessus, la membrane **12** étant illustrée en traits pointillés. Comme on peut le noter, il est possible de réaliser une quantité importante d'éléments **326** sous la membrane **12,** par exemple sous la forme d'une matrice d'éléments régulièrement espacés afin d'obtenir une thermalisation homogène de la membrane **12.** Avantageusement, il est prévu un nombre maximum d'éléments de court-circuit par unité de surface, ce qui permet une thermalisation optimale de la membrane **12.**

Bien entendu, d'autres modes de réalisation sont possibles, notamment concernant la forme et la constitution des membranes des bolomètres de détection et de compensation.

Notamment, les bolomètres de compensation comportent une membrane identique à celle des bolomètres sensibles qui est directement attachée auxdits clous d'ancrage, sans présence de bras d'isolation thermique, une thermalisation supplémentaire de la membrane au substrat étant ainsi obtenue via les clous d'ancrage. En variante, la membrane des bolomètres de compensation est attachée auxdits clous par l'intermédiaire de bras plus courts que ceux des bolomètres sensibles, ce qui a pour effet d'augmenter la thermalisation au substrat des bolomètres de compensation.

## Revendications

1. Détecteur bolométrique comportant :
■ un substrat (14) ;
■ des micro-ponts bolométriques de détection (206) suspendus au-dessus du substrat (14) et thermiquement isolés du substrat (14);
■ des micro-ponts bolométriques de compensation (214) suspendus au-dessus du substrat (14) et thermalisés au substrat (14); et
■ un circuit de lecture (302) formé dans le substrat (14) pour appliquer une polarisation aux micro-ponts de détection (206) et au micro-ponts de compensation (214) et pour former des différences entre des signaux produits par les micro-ponts de détection (206) et des signaux produits par les micro-ponts de compensation (214) sous l'effet de la polarisation appliquée,
chaque micro-pont de détection (206) et chaque micro-pont de compensation (214) comportant des clous d'ancrage (16) électriquement conducteur connectés au circuit de lecture (302), une membrane fixée (12) aux clous d'ancrage (16) au-dessus du substrat (14) et un élément thermométrique (20) agencé dans la membrane (12);
le détecteur bolométrique comportant en outre des éléments de court-circuit thermique (326) entre la membrane (12) de chaque micro-pont de compensation (201) et le substrat (14),
***caractérisé* en ce que** les éléments de court-circuit thermique (326) sous chaque micro-pont de compensation (214) comportent des motifs métalliques agencés sous l'élément bolométrique (20) du micro-pont de compensation et au contact de la membrane (12) du micro-pont de compensation (214) et du substrat (14).

2. Détecteur bolométrique selon la revendication 1, ***caractérisé* en ce que** les membranes des micro-ponts de compensation sont identiques aux membranes des micro-ponts de détection.

3. Détecteur bolométrique selon la revendication 1 ou 2, ***caractérisé* en ce que** les motifs métalliques (326) sont identiques aux clous d'ancrage (16) suspendant la membrane (12) du micro-pont de compensation (214).

4. Détecteur selon la revendication 1, 2 ou 3, ***caractérisé* en ce que** les motifs métalliques sont électriquement isolés de l'élément thermométrique (20) du micro-pont de compensation.

5. Détecteur bolométrique selon l'une quelconque des revendications précédentes, ***caractérisé* en ce que** les motifs métalliques (326) sont sensiblement des cylindres de section circulaire d'un diamètre compris entre 0,25 micromètre et 5 micromètres.

6. Détecteur bolométrique selon l'une quelconque des revendications précédentes, ***caractérisé* en ce que** le nombre de motifs métalliques (326) est compris entre 0,5 et 1,5 par µm².

7. Procédé de fabrication d'un détecteur bolométrique selon l'une quelconque des revendications précédentes, ***caractérisé* en ce qu'**il comporte :
■ la réalisation du substrat (14) et du circuit de lecture (302), le circuit de lecture comportant des plots métalliques (308) aux endroits prévus pour les clous d'ancrage (16) des micro-ponts de détection (206) et des micro-ponts de compensation (214);
■ le dépôt sur la surface du substrat (14) d'une couche sacrificielle (320) ;
■ la réalisation de trous traversants (322, 324) dans la couche sacrificielle aux endroits prévus pour les clous d'ancrage (16) et pour les motifs de court-circuit thermique (326);
■ la métallisation des trous traversants (322, 324);
■ la réalisation des membranes (12) des micro-ponts de détection (206) et des micro-ponts de compensation (214) sur la couche sacrificielle (320) ; et
■ le retrait de la couche sacrificielle (320).
